# EUROPEAN PATENT APPLICATION

(11) **EP 1 229 463 A2**
(43) Date of publication of application: **07.08.2002**
(21) Application number: 02002407.1
(22) Date of filing: 31.01.2002
(51) Int. Cl.: G06F 17/50

(54) **Storage method of substantial data integrating shape and physical properties**

(30) Priority: 01.02.2001 JP 2001025023
(71) Applicant: RIKEN, Wako-shi, Saitama 351-0198 (JP)
(72) Inventor: Kase, Kiwamu, c/o Riken, Wako-shi, Saitama 351-0198 (JP); Tashiro, Hideo, c/o Riken, Wako-shi, Saitama 351-0198 (JP); Himeno, Ryutaro, c/o Riken, Wako-shi, Saitama 351-0198 (JP); Makinouchi, Akitake, c/o Riken, Wako-shi, Saitama 351-0198 (JP)
(74) Representative: Grünecker, Kinkeldey, Stockmair & Schwanhäusser Anwaltssozietät

(57) **Abstract**

There is disclosed a method of storing substantial data integrating shape and physical properties comprising an external data input step (A) for inputting external data 12 consisting of boundary data of an object 1, an Octree division step (B) for dividing, by Octree division, the external data into cubical cells 13 which boundary surfaces are orthogonal to each other, and a cell data storage step (C) for storing the values of various physical properties for each of the cells. Furthermore, in the Octree division step (B), each of the divided cells 13 is classified to internal cells 13a located in the interior of the object, external cells 13b in the exterior thereof and boundary cells 13c including boundary surfaces. Thereby, substantial data integrating shape and physical properties can be stored in small storage capacity, whereby it is possible to manage shape, structure, physical-property information, and history of matter in a unified way, and to manage data associated with a series of processes of from design to work, assembly, test and evaluation under the same data, thus enabling the integration of CAD and simulation.

## Description

### BACKGROUND OF THE INVENTION

### Field of the Invention

The present invention relates to a method of storing substantial data which can store substantial data integrating shape and physical properties in a small storage capacity to integrate CAD and simulation.

### Description of the Related Art

In the location of high technology research and development, with increases in sophistication and complexity, enormous amount of trial and error has been necessary, thereby increasing risk in the course of development. For our country aiming at a science and technology-based country, it is very important to minimize these risks and to achieve increased sophistication and greater efficiency of the development process.

At present, in the location of research and development, simulation means such as CAD (Computer Aided Design), CAM (Computer Aided Manufacturing), CAE (Computer Aided Engineering), CAT (Computer Aided Testing) is used for design, work, analysis, and test, respectively.

Further, due to the benefits arising from the present invention, C-Simulation (Corporation Simulation) of continuous simulation, A-CAM (Advanced CAM) considering work process, and D-fabrication (Deterministic fabrication) providing ultimate accuracy are to be in common use.

In the conventional simulation means described above, an object data is stored by CSG (Constructive Solid Geometry) or B-rep (Boundary Representation).

However, because CSG stores the whole data of an object as an assembly of fine solid models, the data is heavy, so that when installing simulation means of software, enormous amount of data must be treated, thus resulting in a problem that even the use of a high speed computer would take much time for analysis.

Further, B-rep represents an object data by boundaries, and therefore the data is light and less in amount. However, B-rep has a problem that it is not suitable for deformation analysis, because the interior of the boundary plane is treated uniformly.

Furthermore, such data storage means divides an object into meshes suitable for analysis, and then applies a finite-element method to them, as required in heat and fluid analysis, large deformation analysis of solids, and these continuous analyses and the like. As a result, although the results of the analyses can be displayed, it is difficult to integrate CAD and simulation, and thus there is a problem that each process of design, analysis, work, assembly and test can not be managed under the same data.

In other words, in the current state of Solid /Surface-CAD (hereinafter, referred to as S-CAD), there have been the following problems.
(1) Data can not be used commonly in different softwares as it is weak for the data conversion.
(2) It can not be used for simulation directly. As it does not have internal information, the generation of meshes is required.
(3) It can not be used to study machining by CAM because it has only final shapes.

Further, it has the following problems in machining.
(1) It can not represent work processes. It is insufficient to support for rough machining and process design.
(2) It is not suited to new machining techniques such as laser beam machining and high technology machining. It is suited to only cutting and poor accuracy in numerical values.
(3) It does not allow the selection of machining techniques itself for complex material having different properties therein.

### SUMMARY OF THE INVENTION

The present invention has been invented for overcoming these problems. That is, an object of the present invention is to provide a method of storing substantial data, which method enables storing substantial data integrating shape and physical properties in small storage capacity, thereby allowing the managing of shape, structure, physical-property information, and history of matter in a integrated manner, and also the managing of data associated with a series of processes from design to work, assembly, test and evaluation using the same data, thus integrating CAD and simulation.

The present invention provides a method of storing substantial data integrating shape and physical properties, characterized by comprising an external data input step (A) for inputting external data 12 consisting of boundary data of an object (1), an Octree division step (B) for dividing, by Octree division, the external data (12) into cubical cells (13) which boundary surfaces are orthogonal to each other, and a cell data storage step (C) for storing the values of various physical properties for each of the cells.

According to a preferred embodiment of the present invention, in said Octree division step (B), each of the divided cells is classified to internal cells (13a) located in the interior of the object and boundary cells (13b) including boundary surfaces.

Moreover, said boundary cells (13b) is re-divided by the Octree division until acquiring cut points enough to enable the reconstruction of boundary shape elements making up the boundary surfaces included in the external data.

Further, said internal cell (13a) has one kind of physical property value as its attribute and the boundary cell (13b) has two kinds of physical property values of the interior and outside of the solid.

Furthermore, said physical property values consist of constant values, which do not change by simulation, and variables which change as a result of simulation.

Still further, the external data (12) is polygon data representing a polyhedron, a tetrahedron or hexahedron element for a finite-element method, curved surface data for a three dimensional CAD or CG tool, or data for representing the surface of another solid as information comprising partial planes and curved surfaces.

According to the present invention described above, the external data (12) can be stored into small storage capacity as the hierarchy of cubical cells, which cells are obtained by dividing the external data of the object (12) into the cubical cells with orthogonal boundary surfaces by Octree division. Also, as each cell stores various physical properties as its attributes, it is possible to manage shape, structure, physical-property information, and history of matter in a integrated manner, and also to manage data associated with a series of processes from design to work, assembly, test and evaluation under the same data, thus allowing the integration of CAD and simulation.

That is, because the present invention can store and represent not only object data but also physical attributes, it is possible to construct advanced simulation technology and interface technology between human and matter, using the hierarchical data as the platform.

Other objects and advantageous characteristics of the present invention will be apparent from the following description with reference to the accompanying drawings.

### BRIEF DESCRIPTION OF THE DRAWINGS

FIG. 1 is a flow chart showing a method of storing substantial data according to the present invention.
FIG. 2 is a diagrammatic representation of data structure according to the present invention.
FIG. 3 shows examples of interpolating curved-surface.
FIG. 4 is a schematic diagram showing the division method according to the present invention in two dimensions.
FIG. 5 is a schematic diagram showing attributes of each cell of the present invention.
FIG. 6 schematically shows the relationship between V-CAD and V-CAD data according to the present invention and the other simulation means.
FIG. 7 is a schematic diagram showing the comparison of the division method according to the present invention (modified Octree) with the conventional Octree.

### DESCRIPTION OF PREFERRED EMBODIMENT

Hereinafter, an preferred embodiment of the present invention will be described with reference to the drawings.

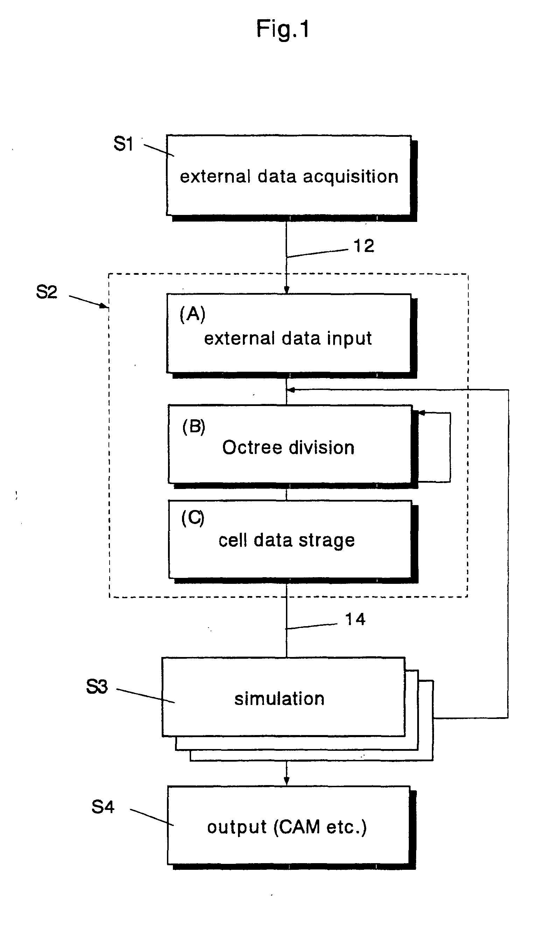

FIG. 1 shows a flow chart illustrating a method of storing substantial data according to the present invention. The method of the present invention comprises an external data input step (A), an Octree division step (B), and a cell data storage step(C). In the external data input step (A), external data 12 consisting of boundary data of the object 1 is input to a computer. The external data 12 is gained in an external data acquisition step S1. The computer have stored the method of the present invention. In the Octree division step (B), the external data 12 is divided by Octree division into cubical cells 13 whose boundary surfaces are orthogonal to each other. In the cell data storage step (C), the values of various physical properties for each of the cells are stored. Further, hereinafter, the data according to the method of the present invention will be referred to as "V-CAD data", and design or simulation using such data will be referred to as "Volume CAD" or "V-CAD"'.

As shown in FIG. 1, in a step S2 corresponding to the method of the present invention, the Octree division step (B) may be repeated as required. Further, in a step S3, simulation, such as design, analysis, work, assembly, and test are performed using V-CAD data 14 and the results are preferably outputed to a output step S4 (as CAM or polygon data).

The external data 12 externally inputed is polygon data representing a polyhedron, a tetrahedron or hexahedron element used for a finite-element method, curved surface data used for a three dimensional CAD or CG tool, or data used for representing the surface of the other solids as information comprising partial planes and curved surfaces.

In addition to such data (refereed to as S-CAD data), the external data 12 may be Volume data having also internal information such as (1) data directly input by a person by V-CAD-specific interface (V-interface), (2) digitized data of surface such as that by measuring instruments, sensors, and digitizers, (3) voxel data used for CT scanner, MRI, and general Volume rendering.

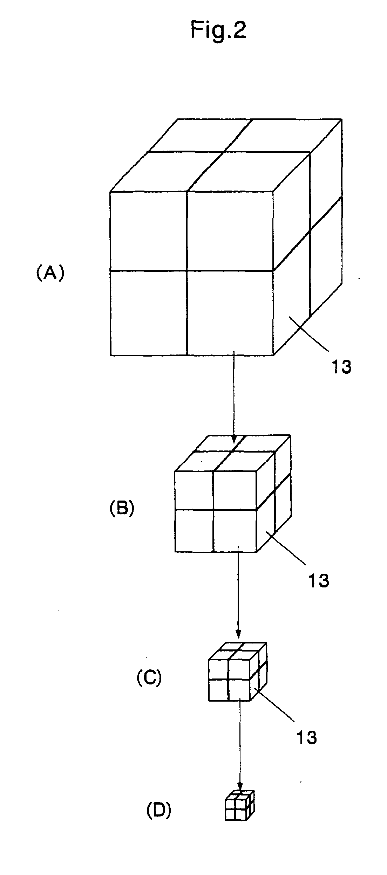

FIG. 2 is a diagrammatic representation of data structure according to the present invention. In the Octree division step(B) described above, space division is performed by modified Octree division. Octree representation, i.e., space division by Octree, divides a reference cube 13 containing an object into 8 regions, and recursivelyrepeat this 8 division process until the solid will be wholly contain in each of the regions, or not contained, as shown in (A), (B), (C), (D). This Octree division can reduce the amount of data more greatly than the voxel representation.

A space region obtained by the space division based on Octree is refered to as a cell 13. The cell is a cube whose boundary planes are orthogonal to each other. The hierarchical structure based on the cells, the number of division or resolution represents regions occupied in space. This enables the object to be represented in the whole space as the accumulation of cells different in size.

That is, in the Octree division step (B), the physical properties of the interior and boundaries are transformed from the external data 12 into substantial data (V-CAD data) 14 as described below. The boundary data, for example, a plane can be strictly reconstructed by 3 points included therein. Or the boundary data are within a designated allowable difference (position, tangential line, normal, curvature, and the threshold designated for connectivity with adjacent parts threof).

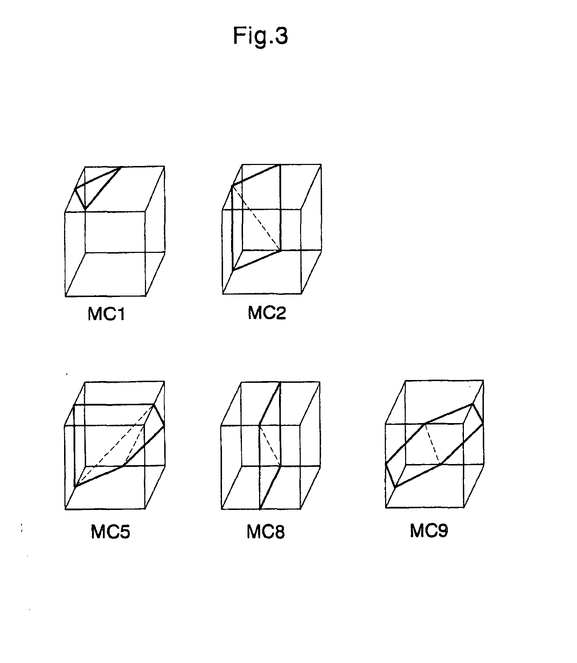

FIG. 3 shows examples of interpolating curved-surface. A special case of the interpolating curved-surface is iso-surface used in Marching Cube. According to the present invention, the division process is repeated until the cell can be represented by a cut point on a ridge line, or until it satisfies normal, main curvature, and connectivity. MC1, MC2, MC5, MC8 and MC9 of iso-surfaces in the Marching Cube shown in Fig.3 can be applied to the present invention.

Further, only geometric eigen--amount is kept using strict representation up to quadratic surfaces, and using approximation by intra-cell curved surface based on quadratic surface for free curved-surfaces.

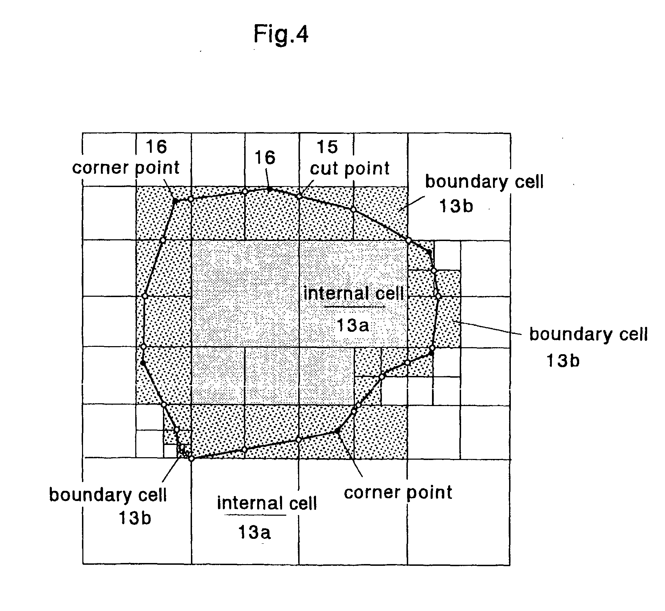

FIG. 4 is a schematic diagram showing the division method according to the present invention in two dimensions. According to the present invention, in the Octree division step (B) described above, each of the divided cells 13 is classified to an internal cell 13a located in the interior of the object and a boundary cell 13b including the boundary surfaces.

That is, the present invention uses the modified Octree for representing boundary cells 13, wherein a cell included wholly in the interior of the boundary is comprised of an internal cell (cube) 13a of largest size, and a cell having boundary information from the external data 12 is comprised of a boundary cell 13. Each boundary cell 13b can be strictly or approximately replaced by cut points 15 (shown by open circles in Figure) on twelve ridge lines in three dimensions and on four ridge lines in two dimensions.

The boundary cell 13b are Octree-divided until cut points 15 are acquired enough to reconstruct boundary shape elements making up a boundary included in the external data 12. The boundary shape elements may be reconstructed strictly for an analyzed curved surface such as a plane and quadratic surface, and approximately for a boundary shape element represented by the other free curved-surface and a discrete point group.

For example, for a line segment, space will be Octree divided until two points on the line segment becomes the cut points 15 on the ridge line, and for a plane until three points will be the cut points, and for a quardratic line until three points, and for a quadratic surface until four points, respectively. In the same manner, for each of polynominal surfaces and rational surfaces, if the representative formulas of the external data are already known, space is hierarchically Octree divided until necessary and sufficient points and ridge lines of the cell are found in the defined range.

That is, the position to be re-divided is divided until a cell satisfies designated resolution on the boundary (surface) area or until the change rates of the values of analysis results (stress, distortion, pressure, flow rate, etc.) will be not higher than designated threshold values.

Further, for the corner points 16 (shown by the blackened circles in Figure) of a boundary cell 13b including a plurality of boundary shape elements, they are not divided more than necessary, because their internal boundaries can be indirectly expressed as lines of intersection of the boundaries which are represented by the cut points 15 in the possession of adjacent boundary-cells. The boundary-cells have sufficient cut-points for reconstruction and divided until they are completely traversed by the boundary elements.

Therefore, V-CAD data 14 includes, as information of shapes stored in the interiors of cells, characteristics for representing the position of cells, the number of division or resolution for representing detail degree in hierarchy, a pointer for representing adjacent cells, the number and coordinate values of cut points, and normal and curvature related to applications.

Further, as V-CAD, the lowest layer holds node information and the values of results in the manner of Euler. How to determine threshold (allowable difference) with respect to the position of boundaries, normal, continuity of tangential lines and each continuity of curvatures is defined such that minimal resolution in re-dividing may be as large as possible.

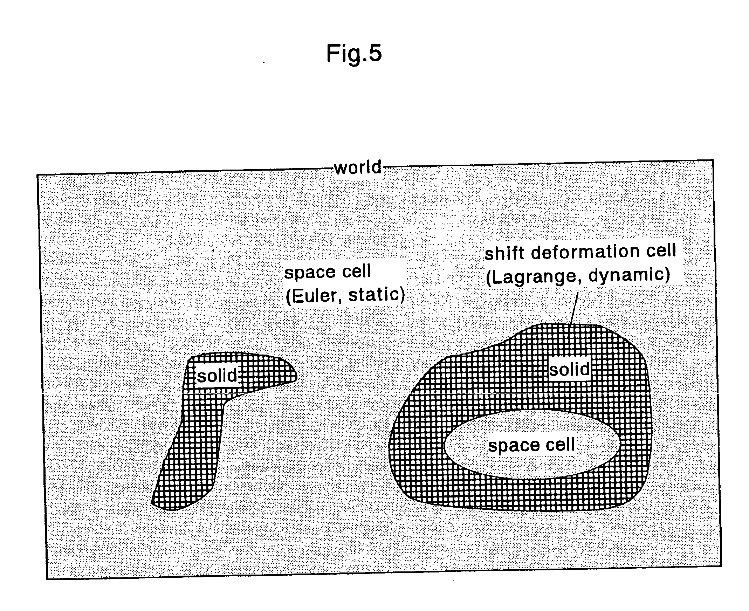

FIG. 5 is a schematic diagram showing attributes of each cell of the present invention. The internal cell 13a described above has one kind of physical property value as its attribute and the boundary cell 13b has two kinds of physical properties which are of the interior and of outside of the object.

That is, although each cell is classified to an internal cell 13a and a boundary cell 13b, and further each of them includes two kinds of space cells (for fluid, Euler) and shift deformation cells (for solid, Lagrange). For V-CAD, only boundary cells 13b have the values of attribute double.

As an initial condition, a cell is space fluid cell (Euler mesh) fixed in all space (world), but, for a solid, it is shift deformation cell (Lagrange mesh) which can freely shift and deform in each simulation. One simulation result is retrieved into V-CAD and incorporated into static world. At this time, boundary information is to be able to reset resolution and the like. For the purpose of redividing/thinning out of object cells after deformation, bidirectional mapping from orthogonal parameter space into a deformed hexahedoron is prepared for an object cell which does not depend on a coordinate system, and a up-and-down shift in hierarchy is performed in the parameter space (orthogonal Octree space), then re-mapping being performed. Also, during reading in, it is necessary to correlate the simulation result with a space cell (indexing in space). Therefore, double structure which contains Laglange in Euler is provided.

Further, the physical property values of each cell can be broadly classified to two groups of constant values, given initially and not changed, and variable values that may change based on the results of simulation.

Among the examples of the constant value; material properties (stiffness coefficient (Young's modulus, yield value), N value (the order of elongation in plastic deformation), tensile strength, Poisson's ratio (shearing strength), temperature, maching speed), friction properties (as the characteristics of antifriction, viscosity, shearing friction coefficient, Coulomb friction), maching (boundary) condition (shift vector of tools, cooling speed).

Among the examples of the variable values; for each cell, stress (symmetrical tensile amount (6 variables), and distortion (symmetrical tensile (6 variables)) and the like, and flow rate, pressure, temperature, and the like. In the process of simulation, when there occurs a difference in variable values larger than an allowable value pre-designated between adjacent internal cells, re-division is automatically performed according to the above described Octree until the difference decreases within the allowable value.

### (Method of automatically determining resolution)

With respect to automatic determination of resolution, in addition to the method based on constraints from shapes and the disparity in physical properties between adjacent cells as already described, there are constraints determined from memory size and computing time, and constraints due to pre-designated absolute accuracy. The pre-designated absolute accuracy means, for example, when the cell width is 1m, division is stopped. When any one of all these constraints is satisfied, the Octree division of space is stopped. This can provide representation having necessary and minimal resolution, thus making implementation more realistic.

### (Method of making full use of V-CAD data)

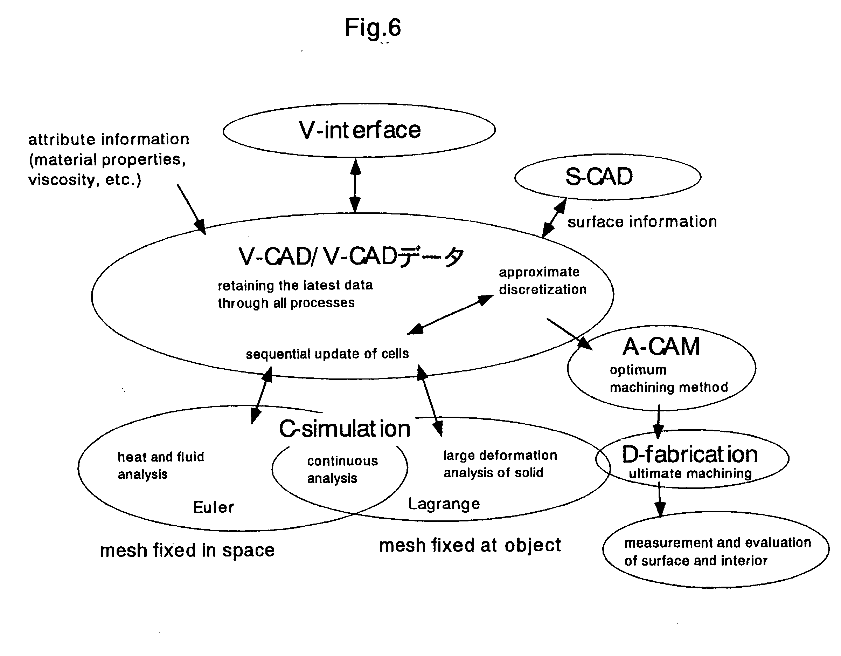

FIG. 6 schematically shows the relationship between V-CAD and V-CAD data according to the present invention and V-interface, S-CAD, A-CAM, D-favricvation, C-simulation.

The method of storing substantial data integrating shape and physical properties according to the present invention is used for representing input, output and intermediate data of analysis/simulation, such as structure analysis of solids, large-deformation analysis (rigid plasticity and elastic plasticity analysis), heat and fluid analysis, flow analysis in C-simulation etc., in addition to shape definition, modification, display, hold, study, evaluation in the design based on S-CAD and the like. Further, it can be also used for generation, analysis, visualization, comparison and evaluation of data for removal processing, addition processing, deformation processing in A-CAM and D-favricvation, and measurement of the surface and interior, data creation for instrumentation, hold of results, display, various analyses, and comparison and analysis with processed data. There are two kinds of display methods of surface rendering and volume rendering.

Table 1 is for comparing V-CAD according to the present invention with S-CAD. From this table, it can be seen that V-CAD according to the present invention is superior to S-CAD in many respects.

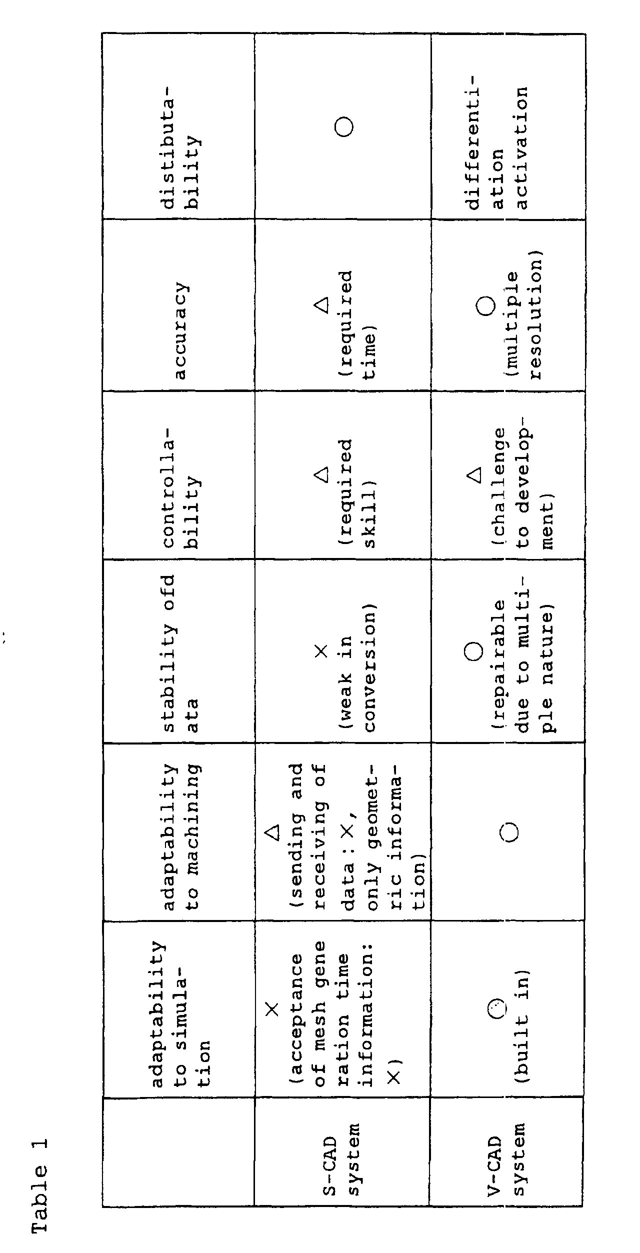

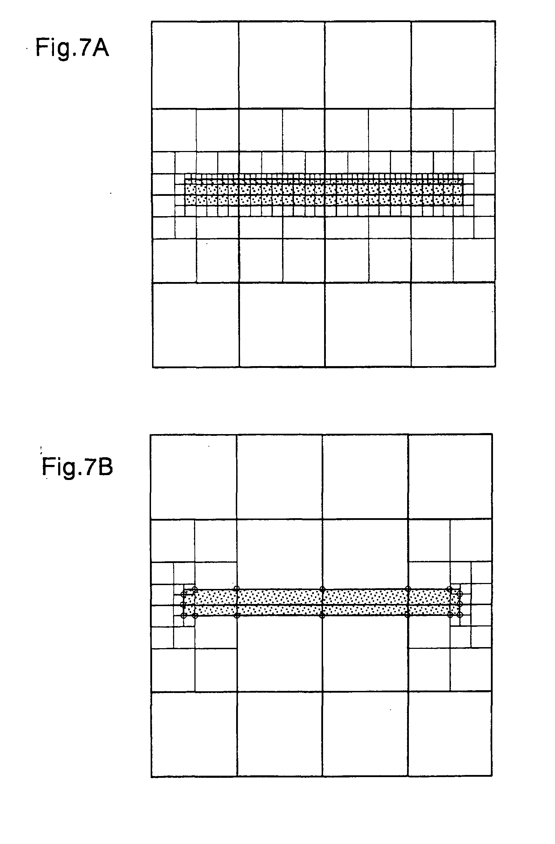

FIGs. 7A and 7B are the same two dimensional schematic diagram as FIG. 4, which shows the comparison of the division method according to the present invention (modified Octree) with the conventional Octree. FIG. 7A shows usual Octree, and FIG. 7B shows an example of modified Octree according to the present invention. This example shows the case of division of a thin board (portion with scattered dots), which is hard for space division method such as Octree to deal with.

From these FIGs. 7A and 7B, it can be seen that the modified Octree according to the present invention requires less division than the usual Octree, because it uses the cut point-based reconstruction of a surface.

According to the method of storing substantial data integrating shape and physical properties according to the present invention, by using V-CAD and V-CAD data, the integration of CAD and simulation can be achieved as a tool for design. Also, it can be integrated with CAM that is a tool for processing. Further, it has usefulness and novelty as a modeling technique for more generally representing an object of real world in a computer, by which shape and physical properties, each separated conventionally, can be integrated and thus "object" can be represented as "object" (substantial data)". Thus, the storage method of the present invention described above has the potential for development that leads to integration of artifact and natural matter.

Although solid CAD as a tool for design is going mainstream as described above, volume CAD is to be the basis for design in next generation. Volume CAD perfectly integrates CAD and simulation, enabling management of each process of design, analysis, machining, assembly, test, and the like under the same data. Also, it is possible to incorporate natural matter such as human body into design and analysis, as well as artifact, thus treating the natural matter as is.

Therefore, the method of storing substantial data integrating shape and physical properties according to the present invention can store the substantial data integrating shape and physical properties in small storage capacity. Thereby, it is possible to manage shape, structure, physical-property information, and history of matter in a unified way, and to manage data associated with a series of processes from design to work, assembly, test, evaluation, and the like under the same data, thus enabling the integration of CAD and simulation. Therefore, the storage method according to the present invention described above has superior advantages.

Further, it is natural that the present invention is not limited to the implementation forms and embodiments as described above, but various modifications can be made without departing from the subject matter of the present invention. For example, the removable electrode according to the present invention is not limited to that for electrolytic dressing grinding shown in FIG. 1 and can be applied to any electrode for electrolytic dressing grinding.

## Claims

1. A method of storing substantial data integrating shape and physical properties, **characterized by** comprising an external data input step (A) for inputting external data (12) consisting of boundary data of an object (1), an Octree division step (B) for dividing, by Octree division, the external data into cubical cells (13) which boundary surfaces are orthogonal to each other, and a cell data storage step (C) for storing the values of various physical properties for each of the cells.

2. The method of storing substantial data integrating shape and physical properties according to claim 1, wherein in said Octree division step (B), each of the divided cells is classified to internal cells (13a) located in the interior of the object and boundary cells (13b) including boundary surfaces.

3. The method of storing substantial data integrating shape and physical properties according to claim 2, wherein said boundary cells (13b) is re-divided by the Octree division until acquiring cut points enough to enable the reconstruction of boundary shape elements including the boundary surfaces included in the external data.

4. The method of storing substantial data integrating shape and physical properties according to claim 2, wherein said internal cell (13a) has one kind of physical property value as its attribute, and the boundary cell (13b) has two kinds of physical property values of the interior and outside of the object.

5. The method of storing substantial data integrating shape and physical properties according to claim 1, wherein said physical property values consist of constant values which do not change by simulation, and variables which change as a result of simulation.

6. The method of storing substantial data integrating shape and physical properties according to claim 1, wherein the external data (12) is polygon data representing a polyhedron, a tetrahedron or hexahedron element for a finite-element method, curved surface data for a three dimensional CAD or CG tool, or data for representing the surface of another solid as information comprising partial planes and curved surfaces.
